# FASCICULE DE BREVET EUROPEEN

(11) **EP 3 745 234 B1**
(45) Date de publication et mention de la délivrance du brevet: **23.04.2025**
(21) Numéro de dépôt: 20176676.3
(22) Date de dépôt: 26.05.2020
(51) Int. Cl.: G06F 1/14, G01R 31/317, G01R 31/3185, H03K 21/40

(54) **DISPOSITIF À PLUSIEURS DOMAINES D'HORLOGE**
VORRICHTUNG MIT MEHREREN TAKTBEREICHEN
DEVICE WITH SEVERAL CLOCK DOMAINS

(30) Priorité: 28.05.2019 FR 1905660
(43) Date de publication de la demande: 02.12.2020
(73) Titulaire: STMicroelectronics (Grenoble 2) SAS, 38000 Grenoble (FR)
(72) Inventeur: MARTIN, Stephane, 38610 GIERES (FR); DUTEY, Denis, 38560 JARRIE (FR)
(74) Mandataire: Cabinet Beaumont

(56) Documents cités:
- US-A- 3 196 258
- US-A- 5 440 604
- US-A1- 2004 205 369
- US-A1- 2013 159 769
- MACGUGAN D C ED - INSTITUTE OF ELECTRICAL AND ELECTRONICS ENGINEERS: "TESTABILITY OF THE PAALS AUTO-ALIGN SENSOR SYSTEM", PROCEEDINGS OF THE DIGITAL AVIONICS SYSTEMS CONFERENCE. LOS ANGELES, OCT. 14 - 17, 1991; [PROCEEDINGS OF THE DIGITAL AVIONICS SYSTEMS CONFERENCE], NEW YORK, IEEE, US, vol. CONF. 10, 14 October 1991 (1991-10-14), pages 381 - 386, XP000309271, ISBN: 978-0-7803-0116-0

## Description

### Domaine technique

La présente description concerne de façon générale les dispositifs électroniques, et plus particulièrement les dispositifs comprenant plusieurs circuits ayant des domaines d'horloge différents et recevant des signaux comprenant des nombres successifs, séparés deux à deux par une même valeur, issus d'une source commune (compteur).

### Technique antérieure

Les dispositifs électroniques comprennent souvent des circuits fonctionnant dans des domaines d'horloge différents, c'est-à-dire avec des signaux d'horloge de fréquences différentes.

Il est connu pour certains circuits de recevoir des signaux comprenant des nombres successifs séparés deux à deux par une même valeur. Par exemple, chaque circuit peut recevoir un signal d'horodatage, c'est-à-dire un signal permettant d'associer une date et une heure à un événement, une information ou une donnée informatique.

Le document US 2004/0205369 décrit un procédé, un système et un circuit de synchronisation pour fournir à un composant matériel un accès à un jeu de valeurs de données sans restriction.

Le document US 3,196,258 décrit un processus de vérification de pas d'un compteur.

Le document "TESTABILITY OF THE PAALS AUTO-ALIGN SENSOR SYSTEM" de Douglas C. MacGugan (Proceegins IEEE/AIAA 10th Digital Avionics Systems Conference du 14 au 17 octobre 1991) décrit a système d'auto alignement trois axes.

Le document US 5,440,604 décrit un processus de détection de dysfonctionnement d'un compteur en utilisant des parités précédentes, courantes et prédites.

Le document US 2013/0159769 décrit un processus de rectification de valeurs de séquences corrompues dans des systèmes distribués.

### Résumé de l'invention

Il existe un besoin d'un dispositif permettant de s'assurer que les signaux à nombres successifs reçus comprennent bien les nombres envoyés.

L'invention est telle que définie dans le jeu de revendications.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, schématiquement et sous forme de blocs, un dispositif comprenant plusieurs circuits d'horloge de fréquences différentes, et recevant des signaux comprenant des nombres successifs, séparés deux à deux par une même valeur, issus d'une source commune (compteur) ;
la figure 2 représente, schématiquement et sous forme de blocs, une partie du dispositif de la figure 1 ;
la figure 3 représente, schématiquement et sous forme de blocs, une autre partie du dispositif de la figure 1 ; et
la figure 4 représente un exemple de fonctionnement du dispositif de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Par domaine d'horloge, on entend un ou plusieurs circuits recevant et fonctionnant avec un même signal d'horloge de manière synchrone.

Divers exemples de mise en œuvre et de réalisation sont exposés par la suite. Indépendamment de la dénomination donnée à ces exemples (modes de réalisation, exemples, variantes, etc.) et des qualificatifs employés (par exemple, de préférence, etc.), seules les parties de description qui sont incluses dans la portée des revendications font partie de la présente invention, les autres exemples n'étant exposés qu'à titre illustratif et n'étant utiles que pour mettre en évidence des aspects spécifiques à l'invention par rapport à ce qui n'en fait pas partie.

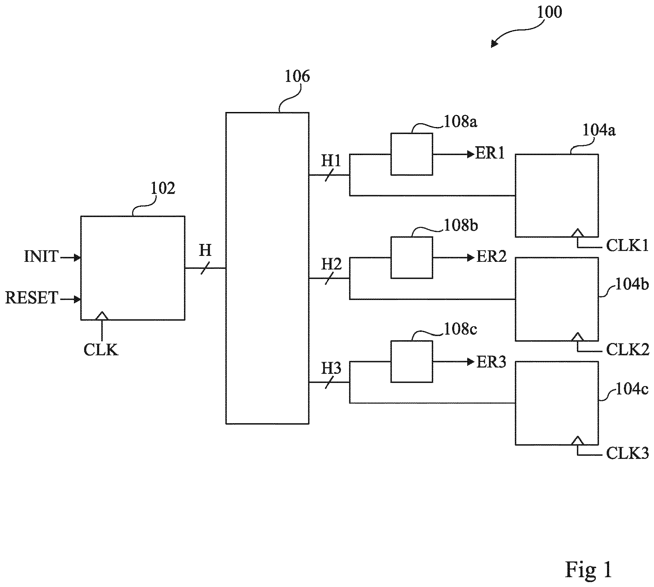

La figure 1 représente, schématiquement et sous forme de blocs, un dispositif 100 comprenant plusieurs circuits de domaines d'horloge différents, c'est-à-dire à horloges de fréquences différentes, et recevant des signaux comprenant des nombres successifs, séparés deux à deux par une même valeur, issus d'une source commune (compteur).

Le dispositif 100 comprend un circuit générateur 102 fournissant un signal H. Le signal H est un signal comprenant des nombres successifs séparés deux à deux par une même valeur constante C. La valeur constante C est par exemple la valeur 1. Ainsi, le signal H comprend par exemple les valeurs suivantes, dans cet ordre : 1 2 3 4 5 6 7 8 9 10 etc. Le signal peut alors être un signal d'horodatage.

Le signal H est par exemple un signal binaire comprenant des nombres codés en hexadécimal, sur 64 bits.

A titre de variante, la valeur constante C peut être toute autre valeur, par exemple la valeur 10, le signal pouvant par exemple comprendre les nombres suivants : 2 12 22 32 42 etc., ou la valeur 5, le signal pouvant par exemple comprendre les nombres suivants : 5 10 15 20 etc.

Le circuit 102 reçoit un signal d'horloge CLK ayant une fréquence f. Le circuit générateur 102 comprend par exemple un compteur incrémentant le signal H de la valeur constante C, par exemple à chaque front montant du signal d'horloge CLK.

Le signal d'horloge CLK peut éventuellement être aussi fourni à une unité de surveillance du signal d'horloge (CMU - Clock Monitoring Unit en anglais), non représentée. Cette unité permet de vérifier que la fréquence de l'horloge est dans une gamme de valeur voulue, par exemple une gamme centrée sur la fréquence f.

Le circuit 102 reçoit un signal comprenant un nombre initial INIT. Le nombre INIT correspond au nombre à partir duquel le circuit 102 incrémente la valeur du signal H.

Dans le cas d'un signal d'horodatage, le nombre initial INIT est par exemple 0.

Le dispositif 100 comprend, de plus, au moins un circuit 104 situé dans un domaine d'horloge différent de celui du circuit 102, c'est-à-dire ayant un signal d'horloge de fréquence différente de la fréquence du signal CLK. La figure 1 représente trois circuits 104a, 104b et 104c recevant respectivement des signaux d'horloge CLK1, CLK2 et CLK3, de fréquences respectives f1, f2 et f3. Dans cet exemple, les fréquences f1, f2 et f3 sont toutes différentes les unes des autres et de la fréquence f. De préférence, les fréquences f1, f2 et f3 sont plus élevées que la fréquence f.

Bien que la figure 1 ne représente que trois circuits 104 et donc trois fréquences f1, f2 et f3, de manière plus générale le dispositif 100 comprend au moins un circuit 104, de préférence au moins deux circuits 104, par exemple entre 1 et 10 circuits 104.

Les circuits 104 sont par exemple des circuits comprenant des unités de traitement de données (CPU), ou des circuits comprenant au moins un périphérique.

Certains circuits 104 peuvent être dans un même domaine d'horloge. De préférence, au moins deux circuits 104 sont dans des domaines d'horloge différents, c'est-à-dire fonctionnent avec des signaux d'horloge ayant des fréquences différentes.

Le dispositif 100 comprend, de plus, un circuit 106. Une entrée du circuit 106 est reliée à la sortie du circuit 102 fournissant le signal H. Le circuit 106 est configuré pour faire passer le signal du domaine d'horloge du circuit 102 aux domaines d'horloge des circuits 104. Le circuit 106 est configuré pour fournir en sortie des signaux correspondant au signal H, chacun de ces signaux étant synchronisé à un signal d'horloge de fréquence différente de la fréquence f du circuit 102. Ainsi, les signaux H1, H2 et H3 représentés en figure 1 comprennent les nombres du signal H dans le même ordre, mais à des fréquences différentes. Plus précisément, le circuit 106 est configuré pour fournir des signaux H1, H2 et H3 synchronisés aux fréquences f1, f2 et f3 des circuits 104a, 104b et 104c.

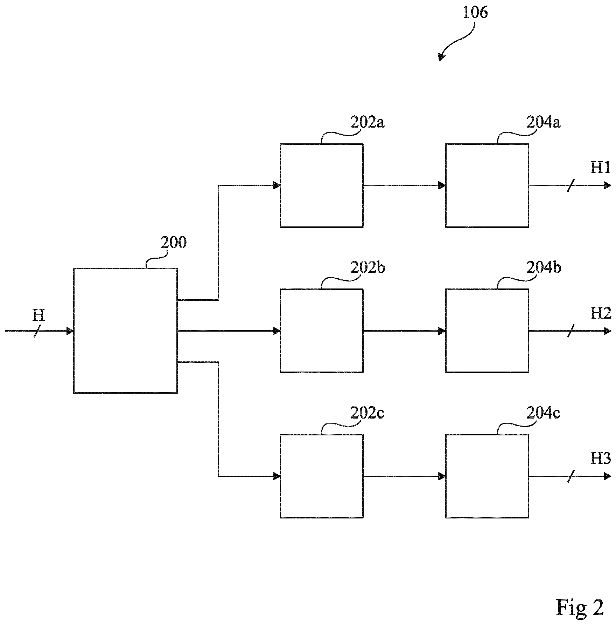

Un exemple d'un circuit 106 est décrit plus en détails en relation avec la figure 2.

Une erreur peut apparaître sur le signal H ou un des signaux H1, H2 et H3, dans le circuit 102 lors de la génération du signal, dans le circuit 106 ou sur un des bus de données qui transmettent les signaux entre les circuits du dispositif 100. Ces erreurs correspondent par exemple au changement d'une valeur d'un bit d'un nombre du signal. Ces erreurs sont par exemple causées par les circuits eux-mêmes, un bit étant par exemple bloqué à une valeur, ou par modification spontanée, par exemple causée par du rayonnement.

Chaque circuit 104 est relié, par une entrée, à une sortie du circuit 106. Plus précisément, le circuit 104a est relié à la sortie du circuit 106 fournissant le signal H1. Le circuit 104b est relié à la sortie du circuit 106 fournissant le signal H2. Le circuit 104c est relié à la sortie du circuit 106 fournissant le signal H3.

Des circuits 108 (108a, 108b et 108c) sont reliés, de préférence connectés, par leurs entrées, aux sorties du circuit 106. Chaque circuit 108 est relié, de préférence connecté, à la même sortie qu'un des circuits 104. Plus précisément, l'entrée du circuit 108a est reliée à la même sortie que celle reliée au circuit 104a, et le circuit 108a reçoit donc le signal H1. L'entrée du circuit 108b est reliée à la même sortie que celle reliée au circuit 104b, et le circuit 108b reçoit donc le signal H2. L'entrée du circuit 108c est reliée à la même sortie que celle reliée au circuit 104c, et le circuit 108c reçoit donc le signal H3.

Le dispositif 100 comprend donc autant de circuits 108 que de circuits 104 pour lesquels on souhaite vérifier l'intégrité du signal H.

Les circuits 108 sont configurés pour vérifier que les nombres successifs des signaux en sortie du circuit 106 sont séparés de la valeur constante C.

Chaque circuit 108 fournit, à une sortie, un signal ER (ER1, ER2, ER3) prenant une première valeur lorsque les nombres successifs du signal H1, H2 ou H3 sont séparés de la valeur constante C et une deuxième valeur lorsqu'ils sont séparés d'une autre valeur que la valeur constante C.

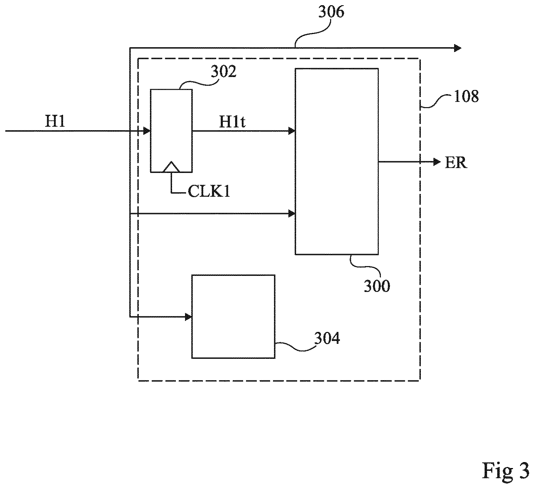

Un exemple d'un circuit 108 est décrit plus en détails en relation avec la figure 3.

Le circuit 102 reçoit, de plus, un signal de réinitialisation RESET. Ainsi, le circuit 102 recommence par exemple à compter depuis le nombre initial INIT à un instant déterminé par le signal RESET, par exemple par un front montant du signal RESET.

Lors du démarrage du dispositif 100 et/ou lors de la réinitialisation du dispositif 100 à un instant déterminé par le signal RESET, le dispositif 100 peut mettre en oeuvre des étapes de vérification du fonctionnement du dispositif 100.

Au cours des étapes de vérification, un nombre prédéterminé est programmé dans le circuit 102, par exemple par une entrée non représentée. Ce nombre est ensuite fourni au circuit 106, puis aux circuits 108. Le circuit 108 peut transmettre le nombre reçu à un circuit pouvant le comparer au nombre programmé dans le circuit 102. Il est alors possible de déterminer si des erreurs sont causées par le dispositif 100 lui-même. De préférence, au moins deux nombres prédéterminés sont envoyés, les deux nombres étant choisis de telle manière que chaque bit formant un nombre du signal est égal à 0 dans au moins un des nombres envoyés et est égal à 1 dans au moins un autre des nombres envoyés. Par exemple, les deux nombres suivants (sous forme hexadécimale) sont envoyés durant les étapes d'initialisation : AAAAAAAA et 55555555.

A titre de variante, le dispositif peut comprendre, pour chaque circuit 104, une unité de surveillance du signal d'horloge (CMU - Clock Monitoring Unit en anglais), non représentée. Chaque unité permet de vérifier que le signal ne reste pas constant dans une fenêtre de temps donnée. L'unité vérifie donc que le signal H change de valeur dans la fenêtre de temps prédéterminée. La fenêtre de temps est par exemple choisie pour être supérieure à la durée entre deux changements de valeur du signal H. L'unité de surveillance peut ainsi détecter un arrêt du circuit 102, par exemple dû à une défaillance.

La figure 2 représente, schématiquement et sous forme de blocs, un exemple d'une partie du dispositif 100 de la figure 1. Plus précisément, la figure 2 représente un exemple d'implémentation du circuit 106.

Le circuit 106 comprend un circuit 200 recevant en entrée le signal H. Le circuit 200 comprend par exemple un encodeur et un démultiplexeur. Ainsi, le signal H est encodé, par exemple en 9 bits, dont 7 bits de données et 2 bits de synchronisation. Le signal encodé est envoyé, par le démultiplexeur, vers plusieurs sorties du circuit 200.

Le circuit 106 comprend des circuits 202. L'exemple de la figure 2 comprend trois circuits 202. Plus généralement, il y a par exemple autant de circuits 202 que de circuits 108 dans le dispositif 100 (figure 1). Chaque sortie du circuit 200 sur laquelle est envoyé le signal H encodé est reliée, de préférence connectée, à l'entrée d'un circuit 202.

Chaque circuit 202 est un translateur asynchrone, ou un circuit de resynchronisation. Chaque circuit 202 est configuré pour faire passer un signal d'un domaine d'horloge à un autre. Chaque circuit 202 est configuré pour faire passer le signal H encodé du domaine d'horloge du circuit 102 (fréquence f) au domaine d'horloge du circuit 104 correspondant (fréquence f1, f2 ou f3).

Le circuit 106 comprend des circuits 204. L'exemple de la figure 2 comprend trois circuits 204. Plus généralement, il y a autant de circuits 204 que de circuits 202.

Une entrée de chaque circuit 204 est reliée, de préférence connectée, à une sortie d'un des circuits 202. En figure 2, une entrée du circuit 204a est reliée à une sortie du circuit 202a, une entrée du circuit 204b est reliée à une sortie du circuit 202b et une entrée du circuit 204c est reliée à une sortie du circuit 202c.

Chaque circuit 204 comprend un décodeur de manière à obtenir, en sortie, des nombres ayant la même taille (le même nombre de bits) que dans le signal H, synchronisé sur le domaine d'horloge correspondant.

La sortie du circuit 204a transmet le signal H1, synchronisé à la fréquence f1, la sortie du circuit 204b transmet le signal H2, synchronisé à la fréquence f2, et la sortie du circuit 204c transmet le signal H3, synchronisé à la fréquence f3.

La figure 3 représente, schématiquement et sous forme de blocs, une autre partie du dispositif 100 de la figure 1. Plus précisément, la figure 3 comprend un exemple d'implémentation du circuit 108. L'exemple de la figure 3 est décrit dans le cas du circuit 108a, recevant en entrée le signal H1. Cependant, les autres circuits 108 sont identiques au circuit décrit en relation avec la figure 3.

Le circuit 108 comprend un circuit de comparaison 300. Le circuit 108 comprend de plus un circuit retardateur 302. Le signal H1 est fourni en entrée du circuit 302 et à une entrée du circuit 300. La sortie du circuit 302 est reliée, de préférence connectée, à une autre entrée du circuit 300. Le signal H1 est aussi fourni en sortie du circuit 108 par une connexion 306.

Le circuit retardateur 302 reçoit en entrée le signal d'horloge CLK1, c'est-à-dire le signal d'horloge du domaine d'horloge du circuit 104a auquel est relié le circuit 108a, et fournit en sortie un signal H1t. Le circuit 302 retarde le signal H1 d'une valeur égale à la période du signal d'horloge CLK1.

Le circuit 300 compare chaque valeur du signal H1 à la valeur précédente du signal H1, cette valeur précédente étant fournie en sortie du circuit 302, de manière à obtenir la différence entre ces valeurs. Par différence, on entend de préférence une différence en valeur absolue, c'est-à-dire une valeur positive. Si cette différence est égale à 0 ou C (la valeur d'incrémentation du circuit 102, ou tout incrément induit par le circuit 106), c'est-à-dire si les deux valeurs sont identiques ou successives, le signal de sortie ER est égal à la première valeur. Si cette différence est égale à toute autre valeur, le signal de sortie est égal à la deuxième valeur.

A titre de variante, le signal de sortie prend la première valeur si la différence est comprise entre 0 et la valeur C et la deuxième valeur si cela n'est pas le cas.

A titre de variante, le signal de sortie prend la première valeur si la différence est comprise entre 0 et une valeur C' et la deuxième valeur si cela n'est pas le cas, la valeur C' étant égale à la valeur C plus une marge de tolérance.

Le circuit 108 comprend en outre un circuit 304. Le circuit 304 reçoit le signal H1 en entrée. Le circuit 304 est configuré pour recevoir le ou les nombres envoyés durant les étapes de vérification décrites en relation avec la figure 1. Le circuit 304 compare le nombre reçu et le nombre envoyé lors des étapes de vérification ou transmet la valeur reçue en utilisant la connexion 306 pour que la comparaison soit faite par un circuit externe non représenté.

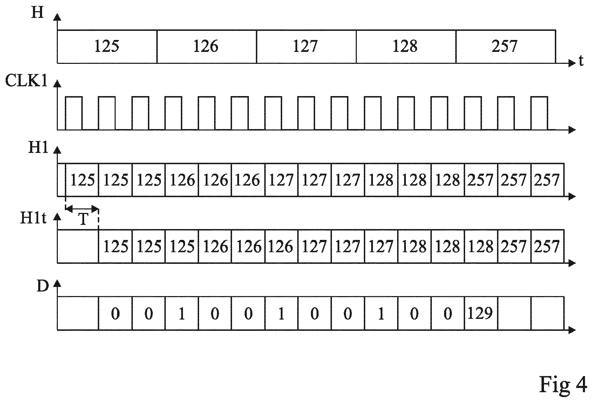

La figure 4 est un chronogramme représentant un exemple de fonctionnement du dispositif 100, par exemple le fonctionnement du circuit 108 de la figure 3.

Le chronogramme représente le signal H, le signal d'horloge CLK1 du domaine d'horloge du circuit 104a, le signal H1, le signal H1t et un signal D de différence entre les signaux H1 et H1t obtenu par le circuit 300.

Les nombres du signal H sont, dans cette partie, successivement 125, 126, 127, 128, 257. On considère en effet dans cet exemple qu'une erreur est apparue, sur le signal H, dans le circuit de génération 102, ou dans le circuit 106 avant la génération du nombre 129 et après la génération du nombre 128.

Le signal H1 correspond au signal H dans un domaine d'horloge différent, ici de fréquence f1 supérieure à f. Ainsi, chaque nombre transmis par le signal H est transmis plusieurs fois successivement par le signal H1. Dans l'exemple de la figure 4, chaque nombre est répété trois fois. En pratique, le nombre de répétition dépend de la fréquence du circuit 102 et la fréquence du circuit 104 correspondant. Pour un même signal, le signal H1 par exemple, certains nombres peuvent être répétés un nombre de fois différent des autres.

Ainsi, la différence, en l'absence d'erreur, entre un nombre transmis par H1 et le nombre précédent est égale à 0 ou à C (ici C est égal à 1).

Le signal H1t est égal au signal H1 retardé d'un temps T correspondant à une période du signal d'horloge CLK1. Ainsi, à chaque instant et lorsqu'il n'y a pas d'erreurs, le nombre transmis par le signal H1t est égal au nombre transmis par le signal H1 durant la période précédente du signal d'horloge CLK1.

Le signal D est égal à la différence entre les signaux H1 et H1t. Ainsi, lorsqu'il n'y a pas d'erreurs, c'est-à-dire avant le nombre 257, le signal D transmet les nombres 0 et 1.

Lorsqu'une erreur apparaît, le nombre transmis par H1 devient 257 dans cet exemple. La différence entre le nombre 257 du signal H1 et le nombre précédent (128) du signal H1t est égale à 129. Ainsi, le signal D prend la valeur 129. L'erreur peut donc être détectée.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, d'autres implémentations du circuit 106 sont possibles.

Enfin, la mise en oeuvre pratique des modes de réalisation et variantes décrits est à la portée de l'homme du métier à partir des indications fonctionnelles données ci-dessus.

## Revendications

1. Dispositif comprenant un premier circuit (102) configuré pour envoyer, à un deuxième circuit (106), un premier signal comprenant des nombres séparés successivement d'une valeur constante (C), le deuxième circuit (106) étant configuré pour fournir en sortie au moins un deuxième signal (H1, H2, H3), chacun des au moins un deuxième signal étant synchronisé à un signal d'horloge d'un domaine d'horloge différent du domaine d'horloge du premier circuit (102), chaque au moins un deuxième signal étant fourni à un troisième circuit (104), chaque troisième circuit (104) étant dans le domaine d'horloge du deuxième signal correspondant, **caractérisé en ce que** chaque au moins un deuxième signal est envoyé, dans chacun des domaines d'horloge différents du domaine d'horloge du premier circuit (102), à un quatrième circuit (108) du dispositif configuré pour fournir une première valeur si les nombres successifs du deuxième signal reçu par le quatrième circuit (108) sont égaux ou séparés de la valeur constante (C), et une deuxième valeur indiquant une erreur si les nombres successifs du deuxième signal reçu par le troisième circuit (104) sont différents et séparés d'une valeur différente de la valeur constante (C), chaque quatrième circuit (108) comprenant un circuit retardateur (302) et un circuit de comparaison (300), le circuit retardateur (302) étant relié entre l'entrée du quatrième circuit (108), sur laquelle est reçu un deuxième signal, et une entrée du circuit de comparaison (300) de manière à générer un deuxième signal retardé, le circuit de comparaison (300) étant configuré pour comparer un nombre dudit deuxième signal (H1) avec un nombre d'un signal correspondant au deuxième signal retardé (H1t).

2. Dispositif selon la revendication 1, dans lequel chaque nombre est un nombre binaire.

3. Dispositif selon la revendication 2, dans lequel chaque nombre comprend 64 bits.

4. Dispositif selon l'une quelconque des revendications 1 à 3, comprenant au moins deux troisièmes circuits (104) dans des domaines d'horloge différents.

5. Dispositif selon l'une quelconque des revendications 1 à 4, dans lequel le premier circuit (102) est un circuit d'horodatage.

6. Dispositif selon l'une quelconque des revendications 1 à 5, dans lequel la valeur constante (C) est égale à **1.**

7. Procédé de vérification du dispositif selon l'une quelconque des revendications 1 à 6, comprenant le transfert d'au moins un nombre prédéterminé du premier circuit (102) au quatrième circuit (108), le nombre reçu par le quatrième circuit (108) étant comparé avec le nombre prédéterminé.

8. Procédé selon la revendication 7, dans lequel au moins deux nombres prédéterminés sont transférés, les deux nombres prédéterminés étant choisis de telle manière que chaque bit formant un nombre est égal à 0 dans au moins un des nombres prédéterminés et est égal à 1 dans au moins un autre des nombres prédéterminés.

9. Procédé selon la revendication 7 ou 8, dans lequel un circuit est configuré pour vérifier que le signal change de valeur dans une fenêtre de temps prédéterminée.

## Patentansprüche

1. Vorrichtung, die eine erste Schaltung (102) aufweist, die konfiguriert ist zum Senden an eine zweite Schaltung (106) eines ersten Signals, das Zahlen aufweist, die aufeinanderfolgend durch einen konstanten Wert (C) getrennt sind, wobei die zweite Schaltung (106) konfiguriert ist zum Ausgeben mindestens eines zweiten Signals (H1, H2, H3), wobei jedes mindestens eine zweite Signal mit einem Taktsignal einer Taktdomäne synchronisiert ist, die sich von der Taktdomäne der ersten Schaltung (102) unterscheidet, wobei jedes mindestens eine zweite Signal einer dritten Schaltung (104) zugeführt wird, wobei sich jede dritte Schaltung (104) in der Taktdomäne des entsprechenden zweiten Signals befindet, **dadurch gekennzeichnet, dass** jedes mindestens eine zweite Signal in jeder der Taktdomänen, die sich von der Taktdomäne der ersten Schaltung (102) unterscheiden, an eine vierte Schaltung (108) der Vorrichtung gesendet wird, die konfiguriert ist zum Liefern eines ersten Werts, wenn die aufeinanderfolgenden Zahlen des von der vierten Schaltung (108) empfangenen zweiten Signals gleich sind oder durch den konstanten Wert (C) getrennt sind, und eines zweiten Werts, der einen Fehler anzeigt, wenn die aufeinanderfolgenden Zahlen des zweiten Signals, das von der dritten Schaltung (104) empfangen wird, unterschiedlich sind und durch einen Wert getrennt sind, der sich von dem konstanten Wert (C) unterscheidet, wobei jede vierte Schaltung (108) eine Verzögerungsschaltung (302) und eine Vergleichsschaltung (300) aufweist, wobei die Verzögerungsschaltung (302) zwischen dem Eingang der vierten Schaltung (108), an dem ein zweites Signal empfangen wird, und einem Eingang der Vergleichsschaltung (300) gekoppelt ist, um ein verzögertes zweites Signal zu erzeugen, wobei die Vergleichsschaltung (300) konfiguriert ist zum Vergleichen einer Zahl des zweiten Signals (H1) mit einer Zahl eines Signals, das dem verzögerten zweiten Signal (H1t) entspricht.

2. Vorrichtung nach Anspruch 1, wobei jede Zahl eine Binärzahl ist.

3. Vorrichtung nach Anspruch 2, wobei jede Zahl 64 Bits aufweist.

4. Vorrichtung nach einem der Ansprüche 1 bis 3, aufweisend mindestens zwei dritte Schaltkreise (104) in unterschiedlichen Taktdomänen.

5. Vorrichtung nach einem der Ansprüche 1 bis 4, wobei der erste Schaltkreis (102) ein Zeitstempelschaltung ist.

6. Vorrichtung nach einem der Ansprüche 1 bis 5, wobei der konstante Wert (C) gleich 1 ist.

7. Verfahren zum Verifizieren der Vorrichtung gemäß einem der Ansprüche 1 bis 6, aufweisend das Übertragen mindestens einer vorbestimmten Zahl von der ersten Schaltung (102) zu der vierten Schaltung (108), wobei die von der vierten Schaltung (108) empfangene Zahl mit der vorbestimmten Zahl verglichen wird.

8. Verfahren nach Anspruch 7, wobei mindestens zwei vorbestimmte Zahlen übertragen werden, wobei die zwei vorbestimmten Zahlen so ausgewählt werden, dass jedes Bit, das eine Zahl bildet, in mindestens einer der vorbestimmten Zahlen gleich 0 ist und in mindestens einer anderen der vorbestimmten Zahlen gleich 1 ist.

9. Verfahren nach Anspruch 7 oder 8, wobei eine Schaltung so konfiguriert ist, dass sie überprüft, ob sich der Wert des Signals in einem vorbestimmten Zeitfenster ändert.

## Claims

1. Device comprising a first circuit (102) configured to send, to a second circuit (106), a first signal comprising numbers successively separated by a constant value (C), the second circuit (106) being configured to output at least one second signal (H1, H2, H3), each of the at least one second signal being synchronized to a clock signal of a clock domain different from the clock domain of the first circuit (102), each at least one second signal being supplied to a third circuit (104), each third circuit (104) being in the clock domain of the corresponding second signal, **characterized in that** each at least one second signal is sent, in each of the clock domains different from the clock domain of the first circuit (102), to a fourth circuit (108) of the device configured to supply a first value if the successive numbers of the second signal received by the fourth circuit (108) are equal or separated by the constant value (C), and a second value indicating an error if the successive numbers of the second signal received by the third circuit (104) are different and separated by a value different from the constant value (C), each fourth circuit (108) comprising a delay circuit (302) and a comparison circuit (300), the delay circuit (302) being coupled between the input of the fourth circuit (108), on which a second signal is received, and an input of the comparison circuit (300) so as to generate a second delayed signal, the comparison circuit (300) being configured to compare a number of said second signal (H1) with a number of a signal corresponding to the second delayed signal (H1t).

2. Device according to claim 1, wherein each number is a binary number.

3. Device according to claim 2, wherein each number comprises 64 bits.

4. Device according to any of claims 1 to 3, comprising at least two third circuits (104) in different clock domains.

5. Device according to any of claims 1 to 4, wherein the first circuit (102) is a timestamping circuit.

6. Device according to any of claims 1 to 5, wherein the constant value (C) is equal to 1.

7. Method of verifying the device according to any of claims 1 to 6, comprising the transfer of at least one predetermined number from the first circuit (102) to the fourth circuit (108), the number received by the fourth circuit (108) being compared with the predetermined number.

8. Method according to claim 7, wherein at least two predetermined numbers are transferred, the two predetermined numbers being selected so that each bit forming a number is equal to 0 in at least one of the predetermined numbers and is equal to 1 in at least another one of the predetermined numbers.

9. Method according to claim 7 or 8, wherein a circuit is configured to verify that the value of the signal changes in a predetermined time window.
